# EUROPEAN PATENT APPLICATION

(11) **EP 1 441 241 A1**
(43) Date of publication of application: **28.07.2004**
(21) Application number: 03405721.6
(22) Date of filing: 08.10.2003
(51) Int. Cl.: G02B 5/28, C23C 16/26

(54) **Process for interferential colouring of metal objects using a carbon plasma jet**

(30) Priority: 14.10.2002 CH 17072002
(71) Applicant: Argor-Heraeus S.A., 6850 Mendrisio (CH)
(72) Inventor: Guidali, Roberto, c/o Argor-Heraeus S.A., 6850 Mendrisio (CH)
(74) Representative: Fiammenghi-Domenighetti, Delfina

(57) **Abstract**

A process for differentiated colouring of the surface of a metal object (1) which comprises applying layers (2, 3) of amorphous adamantine substance of different thickness to the surface of the said metal object using a carbon plasma jet in such a way that the light rays (ε, ε') reflected from the said surface (1s) of the metal objects (λ, λ') and those reflected from the outer surfaces (2s, 3s) of the said layers (2, 3) of different thickness interfere generating different hues and/or colours depending upon the thicknesses of the said layers (2, 3) is described.

## Description

This invention relates to all technological and industrial fields in which it is necessary to provide different colours on the surfaces of metal objects.
The invention primarily relates to the fields of jewellery and watchmaking. In these fields in particular the operation of colouring particular components of a jewel or a watch is especially problematical, particularly when colours other than those of the base metal or alloy have to be applied. The problems are even more complex when it is desired to apply a colouring consisting of zones of different colour on a particular component.

Recourse to the application of layers of enamel or the like, apart from not providing a reliable result over time, results in thickening of the part treated which in many cases, for example in the case of the hands of a clock, is incompatible from the aesthetic and functional points of view.
The applicant has recently conceived a process for the protection of metal objects consisting of the application of a thin layer of adamantine substance from a carbon plasma. The interpenetration at molecular level between the applied layer and the surface of the metal object in fact makes it possible to achieve the desired result of protecting the object in a permanent way.

In connection with this process the applicant has lodged European patent application no. 96928749.9, in which all the implementational aspects of the process are described.

In the course of research and laboratory tests relating to this new technology the inventor of the process described in this application has found that it is possible to alter the "apparent" colour of the amorphous adamantine layer applied, that is the physical characteristics of the light rays emitted by it which reach an observer's eye, merely by slightly altering its thickness.

It therefore occurred to him that by suitably and appropriately changing the thickness of the aforesaid layer or by applying a layer consisting of several adjacent areas of different thickness it would be possible to obtain different colours for a number of objects or different parts of the same object. Moreover this is achieved by applying layers of extremely small thickness which do not appreciably alter either the shape or the weight of an object. The permanence of such colouring, another advantageous aspect, has already been mentioned above.

As will be better seen below, the different colours which can be obtained with layers of different thickness depend on differing interference and combination between the monochromatic radiations comprising the rays reflected from the outer surface of a layer and those reflected from the underlying metal surface to which it has been applied.
The object of this invention therefore comprises a process for differentiated colouring of the surface of metal objects as described in appended claim 1.

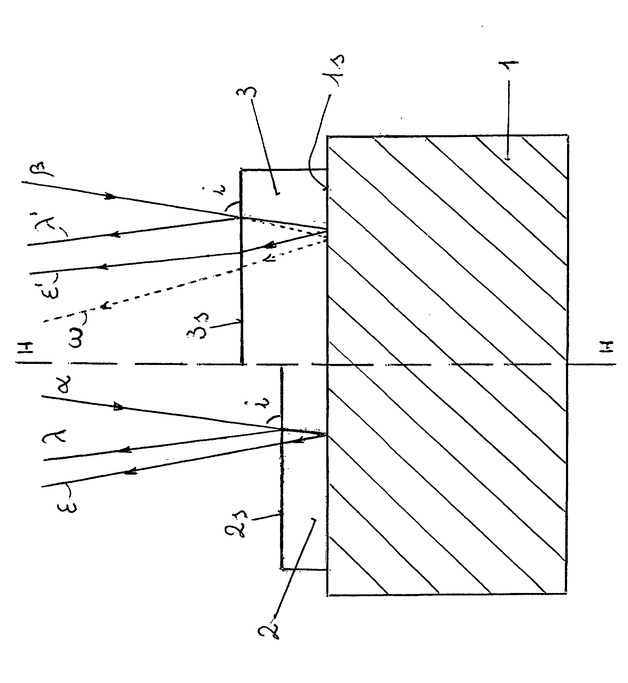

A more detailed description of the features of the process will be provided below with reference to the appended figure which shows a longitudinal cross-section of a metal object onto which two adjacent layers of amorphous adamantine substance, of different thickness, have been applied. It will be noted that the thickness of the two layers has been greatly magnified for obvious reasons of clarity of representation.

With reference to the said figure it will be seen that two layers 2, 3 of amorphous adamantine substance have been applied to the surface 1s of a given metal object 1 using a carbon plasma jet. These two layers are separated from each other by the vertical dashed line H-H. The paths travelled by two parallel light rays α and β which are incident on the outer surfaces 2s, 3s of said layers 2, 3 at the same angle i are shown in the figure. It will be seen from the drawing that while rays λ, λ' reflected from the outer surfaces of these layers are parallel to each other, the rays ε, ε' which are reflected from surface 1s of metal object 1 have a different inclination caused by the different amount of deviation which they have undergone through the effect of refraction through the layers 2, 3 of different thickness through which they have travelled along paths of different length. As a consequence, while ray ε diverges from ray λ and does not therefore meet it, rays λ' and ε' interfere with each other as a result of their convergence, depending on the thickness of layer 3. Thus because light radiation of the solar type is, as is known, decomposed by refraction (prism effect) into primary monochromatic radiations which are deviated by different amounts by the same thickness of refracting layer, for a particular thickness only some of these rays, with a wavelength lying in a particular range, will interfere significantly with ray ε' reflected directly from surface 1s, combining with it in opposite phase and therefore being cancelled out. By suitably adjusting the thicknesses of layers 2, 3 it is therefore possible to ensure that only radiation in a given wavelength range corresponding to the hue of just one colour does not interfere with rays λ, λ', which because it diverges from them can therefore be seen by an observer.

The phenomenon described above has been shown diagrammatically in the right hand part of the drawing in relation to layer 3 which is of greatest thickness. A dashed line indicates the path of monochromatic radiation ω, which after being reflected by the surface 1s of metal object 1 and leaving the surface 3s of layer 3 diverges from the ray λ' which is directly reflected from the aforesaid surface 3s, with which it does not therefore interfere.
This monochromatic radiation ω, with its intrinsic colour, is therefore the only one which can be seen by an observer.

It is obviously preferable to apply a single layer of constant thickness, which is therefore monochromatic, to each metal object 1. However, if manufacturing requirements make it necessary, several adjacent layers of different thickness may also be applied as indicated in the drawing by way of example.
The inventor suggests that layers of amorphous adamantine substance of thickness between 0.02 and 3 µm should be applied.

## Claims

1. Process (1s) for differentiated colouring of the surface of a metal object (1), **characterised in that** it comprises applying layers (2, 3) of amorphous adamantine substance of different thickness onto the surface of the said metal object using a carbon plasma jet in such a way that the light rays (ε, ε') reflected from the said surface (1s) of the metal objects (λ, λ') and those reflected from the outer surfaces (2s, 3s) of the said layers (2, 3) of different thickness interfere generating different hues and/or colours depending upon the thickness of the said layers (2, 3).

2. Process according to Claim 1 in which the thickness of the said layers (2, 3) lies between 0.02 and 3 µm.
